# EUROPÄISCHE PATENTSCHRIFT

(11) **EP 1 917 686 B1**
(45) Veröffentlichungstag und Bekanntmachung des Hinweises auf die Patenterteilung: **27.06.2018**
(21) Anmeldenummer: 06775719.5
(22) Anmeldetag: 20.07.2006
(51) Int. Cl.: H01L 33/00

(54) **VERFAHREN ZUM HERSTELLEN EINES LUMINESZENZDIODENCHIPS UND LUMINESZENZDIODENCHIP**
METHOD FOR PRODUCING AN LED CHIP AND LED CHIP
PROCEDE DE FABRICATION D'UNE PUCE A DIODES LUMINESCENTES ET PUCE A DIODES LUMINESCENTES

(30) Priorität: 26.08.2005 DE 102005040558
(43) Veröffentlichungstag der Anmeldung: 07.05.2008
(73) Patentinhaber: OSRAM Opto Semiconductors GmbH, 93055 Regensburg (DE)
(72) Erfinder: BRUNNER, Herbert, 93161 Sinzing (DE); EISSLER, Dieter, 93152 Nittendorf (DE); FISCHER, Helmut, 93138 Lappersdorf (DE); GUENTHER, Ewald, Karl, Michael, 93128 Regenstauf (DE); HEINDL, Alexander, 93326 Abensberg (DE)
(74) Vertreter: Epping - Hermann - Fischer
(86) Internationale Anmeldenummer: PCT/DE2006/001262
(87) Internationale Veröffentlichungsnummer: WO 2007/022741

(56) Entgegenhaltungen:
- EP-A- 1 198 016
- EP-A- 1 592 074
- WO-A-2004/112154
- WO-A-2005/106978
- US-A1- 2003 080 341

## Beschreibung

Diese Patentanmeldung beansprucht die Priorität der deutschen Patentanmeldung 102005040558.4. Die Erfindung betrifft Verfahren zum Herstellen mindestens eines Lumineszenzdiodenchips, der mit einem Lumineszenzkonversionsmaterial versehen ist, das mindestens einen Leuchtstoff aufweist. Weiterhin betrifft die Erfindung einen derartigen Lumineszenzdiodenchips selbst oder solche Lumineszenzdiodenchips.

Bei optoelektronischen Bauelementen, die elektromagnetische Strahlung emittieren, ist es bekannt, Lumineszenzdiodenchips mittels einer Vergussmasse einzukapseln, in die mindestens ein Leuchtstoff gemischt ist. Das Einkapseln erfolgt zum Beispiel durch Vergießen einer Gehäusekavität, in der ein Lumineszenzdiodenchip montiert ist. Alternativ erfolgt das Einkapseln durch Umspritzen eines auf einem Leiterrahmen montierten Lumineszenzdiodenchips, beispielsweise mittels Spritzpressen.

Der Leuchtstoff ist durch eine von dem Lumineszenzdiodenchip emittierte elektromagnetische Primärstrahlung anregbar und emittiert eine Sekundärstrahlung, wobei die Primärstrahlung und die Sekundärstrahlung unterschiedliche Wellenlängenbereiche aufweisen. Ein gewünschter resultierender Farbort des Bauelements kann beispielsweise durch ein Einstellen eines Mischungsverhältnisses der Primärstrahlung und Sekundärstrahlung eingestellt werden.

Bei einer Verwendung der oben erwähnten Vergussmassen kann es zu Farbortschwankungen aufgrund einer inhomogenen Verteilung des Leuchtstoffes in der Vergussmasse kommen, die zum Beispiel auf einer Sedimentationsbildung von Leuchtstoffpartikeln beruhen kann. Zudem gibt es Fertigungstoleranzen bezüglich einer Dosierbarkeit der Vergussmasse, der Höhen von Lumineszenzdiodenchips und/oder einer Positionierbarkeit der Lumineszenzdiodenchips in der Kavität eines Spritzwerkzeugs. Dies kann zu signifikanten Schwankungen der Menge der Vergussmasse, die dem Lumineszenzdiodenchip in einer Abstrahlrichtung nachgeordnet ist, und somit auch zu Schwankungen des Farbortes des Bauelementes führen. Weiterhin wirken sich hohe Anschaffungskosten für Zubehör zum präzisen Dosieren der Vergussmasse und ein Verschleiß dieses Zubehörs aufgrund der Abrasivität des Lumineszenzkonversionsmaterials beziehungsweise des Leuchtstoffs in nicht zu vernachlässigender Weise auf die Herstellungskosten des Bauelements aus.

In der US 2003/080341 A1 ist ein Verfahren offenbart, bei dem eine Mehrzahl von LED-Chips auf einem Submount mechanisch und elektrisch montiert sind, wobei eine vorgefertigte Maske auf dem Submount derart angeordnet wird, dass sich die LED-Chips in Löchern der Maske befinden, die nachfolgend mit einem Lumineszenzkonversionsmaterial gefüllt werden und wobei die Maske nachfolgend entfernt wird. Der LED-Chip kann in einer Kavität eines Gehäuses angeordnet sein, wobei Seitenflächen der Kavität zu einer Montagefläche des Gehäuses schräg ausgebildet sein können.

Die EP 1 198 016 A2 beschreibt ein Verfahren zum Herstellen von Bauelementen mit LED-Chips, bei dem Flip-Chips auf einem Submount montiert werden, eine Maske mit Öffnungen derart auf dem Submount angeordnet wird, dass sich die Flip-Chips innerhalb der Öffnungen befinden, die Öffnungen mit Lumineszenzkonversionsmaterial gefüllt werden und die Maske nachfolgend entfernt wird.

Die Druckschriften WO 2004/112154 A1, EP 1 643 566 A1, EP 1 592 074 A2 und WO 2005/106978 A1 offenbaren unter anderem ein Verfahren, bei dem LED-Chips auf einem Träger aufgebracht sind. Die LED-Chips können mit einem Lumineszenzkonversionsmaterial versehen werden.

In der WO 01/65613 A1 ist ein Verfahren zur Herstellung von Halbleiterbauelementen offenbart, bei dem ein Lumineszenzkonversionselement direkt auf den Halbleiterkörper aufgebracht wird. Dies hat den Vorteil, dass Leuchtstoffe homogen und in einer wohl definierten Menge auf dem Halbleiterkörper aufgebracht werden können. Dadurch lässt sich ein homogener Farbeindruck des lichtabstrahlenden Halbleiterchips erreichen.

Bei dem Verfahren wird der Halbleiterkörper auf einem Träger montiert, mit Kontakten versehen und mit einem Lumineszenzkonversionselement beschichtet. Das Beschichten erfolgt mittels einer geeigneten Suspension, die ein Lösungsmittel aufweist, das nach dem Auftragen entweicht. Alternativ wird der Halbleiterkörper mit einem Haftvermittler beschichtet, auf dem nachfolgend der Leuchtstoff aufgebracht wird.

Es ist eine Aufgabe der vorliegenden Erfindung, alternative Verfahren zum Herstellen von mit einem Lumineszenzkonversionsmaterial versehenen Lumineszenzdiodenchips bereitzustellen, das es insbesondere ermöglicht, das Lumineszenzkonversionsmaterial in einer wohl definierten Menge und mit einer wohl definierten Struktur aufzubringen. Zudem soll zumindest ein mit einem Lumineszenzkonversionsmaterial versehener Lumineszenzdiodenchip angegeben werden, bei dem das Lumineszenzkonversionsmaterial in einer besonders vorteilhaften Form vorliegt und/oder der auf technisch einfache Weise herstellbar ist.

Diese Aufgabe wird durch ein Verfahren gemäß Anspruch 1 oder Anspruch 9 sowie durch einen Lumineszenzdiodenchip gemäß Anspruch 12 oder Anspruch 14 gelöst. Vorteilhafte Ausführungsformen und bevorzugte Weiterbildungen der Verfahren und des Lumineszenzdiodenchips sind Gegenstand der abhängigen Patentansprüche.

Es wird ein Verfahren angegeben, bei dem ein Grundkörper bereitgestellt wird, der eine Schichtenfolge für den Lumineszenzdiodenchip aufweist, die geeignet ist, eine elektromagnetische Strahlung zu emittieren. Bevorzugt ist der Grundkörper für eine Mehrzahl von Lumineszenzdiodenchips vorgesehen, so dass eine Mehrzahl von Lumineszenzdiodenchips im Wesentlichen gleichzeitig hergestellt werden können. In diesem Fall umfasst das Verfahren insbesondere ein Zerteilen des Grundkörpers zum Vereinzeln der Lumineszenzdiodenchips aus ihrem gemeinsamen Verbund. Besonders bevorzugt ist der Grundkörper ein Wafer oder ein Träger, auf dem die Schichtenfolge oder mehrere solcher Schichtenfolgen aufgebracht sind.

Bei dem Verfahren wird auf zumindest eine Hauptfläche des Grundkörpers eine Deckschicht aufgebracht. Zudem umfasst das Verfahren einen Verfahrensschritt, bei dem mindestens eine Kavität in die Deckschicht eingebracht wird.

Gemäß einer Ausführungsform des Verfahrens wird Lumineszenzkonversionsmaterial derart auf den Grundkörper aufgebracht, dass die Kavität der Deckschicht vollständig oder teilweise gefüllt wird. Dies bietet vorteilhafter Weise die Möglichkeit, die Form des Lumineszenzkonversionsmaterials mittels der Form der Kavität einzustellen, was auf eine präzise Weise erfolgen kann.

Die Deckschicht weist gemäß einer erfindungsgemäßen Ausführungsform ein photostrukturierbares Material auf. Das Einbringen der Kavität umfasst zweckmäßigerweise Photostrukturieren, das heißt ein Strukturieren durch gezieltes Belichten des photostrukturierbaren Materials und ein nachfolgendes selektives Entfernen des belichteten oder des unbelichteten Materials, je nach Beschaffenheit des photostrukturierbaren Materials. Photostrukturieren lässt sich mit Vorteil präzise durchführen und für die Herstellung sehr kleiner Strukturen verwenden. Grundsätzlich sind Auflösungen im Mikrometer- und sogar Sub-Mikrometerbereich möglich.

Nach dem Aufbringen des Lumineszenzkonversionsmaterials wird die Deckschicht mit Vorteil vollständig entfernt. Gemäß einer erfindungsgemäßen Ausführungsform wird jedoch nach dem Aufbringen des Lumineszenzkonversionsmaterials nur ein Teil der Deckschicht selektiv entfernt. Der übrige Teil der Deckschicht bleibt auf dem Grundkörper bestehen und kann verschiedene Funktionen erfüllen, wie nachfolgend angegeben wird. Gemäß einer weiteren alternativen Ausführungsform ist zweckmäßigerweise vorgesehen, die Deckschicht nach dem Aufbringen des Lumineszenzkonversionsmaterials überhaupt nicht zu entfernen.

Das Entfernen der Deckschicht oder von Teilen der Deckschicht erfolgt bevorzugt im wesentlichen mechanisch. Es kann zweckmäßigerweise zusätzlich oder alternativ chemisch erfolgen.

In den Fällen, dass die Deckschicht nicht oder nur teilweise entfernt wird, ist in einer Weiterbildung des Verfahrens vorgesehen, dass die Deckschicht mindestens einen Leuchtstoff aufweist. Damit kann die Deckschicht selbst mit Vorteil als ein Lumineszenzkonversionselement fungieren.

Gemäß einer weiteren vorteilhaften Ausführungsform besteht die Deckschicht aus reflektierendem Material oder weist ein reflektierendes Material auf. Dadurch ist es insbesondere möglich, die Deckschicht als einen Reflektor zu verwenden, beispielsweise um eine von dem Lumineszenzdiodenchip und/oder dem Lumineszenzkonversionsmaterial emittierte elektromagnetische Strahlung in eine gewünschte Abstrahlrichtung oder einen gewünschten Abstrahl-Raumwinkel umzulenken.

Gemäß einer weiteren vorteilhaften Ausführungsform weist der Grundkörper auf der Hauptfläche mindestens eine elektrische Kontaktfläche zum elektrischen Anschließen des mindestens einen Lumineszenzdiodenchips auf. Die Kavität wird lateral versetzt zu der Kontaktfläche in der Deckschicht eingebracht und die Deckschicht wird nach dem Aufbringen des Lumineszenzkonversionsmaterials von der Kontaktfläche entfernt. Somit dient die Deckschicht nicht nur dazu, das Lumineszenzkonversionsmaterial in einer wohl definierten Form aufzubringen, sondern auch zum wenigstens teilweisen Freihalten der elektrischen Kontaktfläche von Lumineszenzkonversionsmaterial. Zusätzlich oder alternativ zu elektrischen Kontaktflächen können selbstverständlich auch weitere Flächen entsprechend von Lumineszenzkonversionsmaterial freigehalten werden. Dies gilt insbesondere für Bereiche, in denen der Grundkörper zum Vereinzeln einer Mehrzahl von Lumineszenzdiodenchips aus ihrem gemeinsamen Verbund zerteilt wird. Für diese Bereiche ist es vorteilhaft, wenn sie frei von Lumineszenzkonversionsmaterial sind, so dass der Grundkörper in diesen Bereichen beispielsweise frei mit einem Sägeblatt zugänglich ist.

Das Lumineszenzkonversionsmaterial weist bevorzugt mindestens ein Material aus der Gruppe bestehend aus Silikonen, Siloxanen, Spin-on Oxiden und photostrukturierbaren Materialen auf. Besonders bevorzugt ist das Material stabil gegenüber der Einwirkung von elektromagnetischer Strahlung, insbesondere von elektromagnetischer Strahlung aus dem ultravioletten Bereich.

In einer zweckmäßigen Ausführungsform des Verfahrens wird das Lumineszenzkonversionsmaterial in Form eines flüssigen, härtbaren Stoffes aufgebracht und nachfolgend gehärtet. Das Lumineszenzkonversionsmaterial wird insbesondere in einer zähflüssigen Form aufgebracht. In flüssiger Form passt sich das Material der Form der Kavität an. Durch das Härten behält das Lumineszenzkonversionsmaterial diese Form dauerhaft selbst wenn die Deckschicht nachfolgend teilweise oder vollständig entfernt werden sollte.

In einer besonders bevorzugten Ausführungsform wird überschüssiges Lumineszenzkonversionsmaterial vor dem Härten zumindest teilweise durch Abstreifen entfernt. Das Lumineszenzkonversionsmaterial wird insbesondere von der Deckschicht abgestriffen, wobei auch nur teilweise gefüllte Kavitäten weitergehend durch Lumineszenzkonversionsmaterial gefüllt werden können. Durch das Abstreifen des Lumineszenzkonversionsmaterials wird zudem die Deckschicht besser zugänglich gemacht, um sie nachfolgend beispielsweise zumindest teilweise zu entfernen.

Gemäß einer weiteren Ausführungsform des Verfahrens wird eine photostrukturierbare Deckschicht auf die Hauptfläche des Grundkörpers aufgebracht, wobei diese Deckschicht den mindestens einen Leuchtstoff aufweist. Somit dient bereits die Deckschicht mit Vorteil als ein Lumineszenzkonversionsmaterial. Dieses kann auf präzise Weise unmittelbar mittels Photostrukturieren strukturiert werden. Die Verwendung eines weiteren Lumineszenzkonversionsmaterials kann mit Vorteil entfallen.

Bevorzugt wird mindestens eine Kavität in die Deckschicht eingebracht, was insbesondere Photostrukturieren umfasst. Die Kavität kann in dieser Ausführungsform des Verfahrens insbesondere eingebracht werden, um Flächen des Grundkörpers, auf denen kein Lumineszenzkonversionsmaterial und/oder sonstiges Material erwünscht ist, freizulegen. Insbesondere können durch Kavitäten elektrische Kontaktflächen und/oder Bereiche, in denen der Grundkörper durchtrennt werden soll, freigelegt werden.

Die Kavität wird mit Vorteil derart eingebracht, dass ihre Innenwände nicht parallel zueinander oder nicht vollständig senkrecht zu einer Haupterstreckungsebene der Hauptfläche verlaufen. Vielmehr wird die Kavität bevorzugt derart eingebracht, dass ihr Querschnitt sich mit zunehmender Tiefe verändert. Gemäß einer Ausführungsform wird der Querschnitt mit zunehmender Tiefe größer, alternativ wird er mit zunehmender Tiefe kleiner.

Zusätzlich oder alternativ wird die Kavität mit besonderem Vorteil derart eingebracht, dass ihre Innenwände zumindest zum Teil bezüglich einer Haupterstreckungsebene der Hauptfläche schräg oder gekrümmt verlaufen. Dadurch lässt sich die Form des Lumineszenzkonversionsmaterials und somit auch eine zu erzeugende Abstrahlcharakteristik oder ein zu erzeugender Farbort des Lumineszenzdiodenchips mittelbar einstellen.

Besonders bevorzugt ist die Deckschicht photostrukturierbar und wird der Verlauf des Querschnitts oder der Innenwände der Kavität zumindest teilweise durch ungleichmäßig starkes Belichten der Deckschicht beim Photostrukturieren eingestellt. Dadurch, dass unterschiedliche Bereiche der Deckschicht mit unterschiedlicher Strahlungsleistung belichtet werden, kann erreicht werden, dass die Deckschicht in den weniger stark belichteten Bereichen nicht in seiner vollen Tiefe und mit variierender Tiefe beleuchtet wird. Die Grenzfläche von beleuchteten und nicht beleuchteten Bereichen der Deckschicht verläuft dadurch an den entsprechenden Stellen nicht parallel zur Ausbreitungsrichtung des zum Beleuchtung einfallenden Lichtes, sondern sie kann insbesondere gekrümmt oder schräg dazu verlaufen.

Es wird ein Lumineszenzdiodenchip mit einem Grundkörper angegeben. Der Grundkörper ist geeignet, elektromagnetische Strahlung zu emittieren. Er ist auf zumindest einer Hauptfläche mit einem Lumineszenzkonversionsmaterial versehen, das mindestens einen Leuchtstoff aufweist.

Das Lumineszenzkonversionsmaterial liegt gemäß einer bevorzugten Ausführungsform als eine Schicht vor, deren Seitenflanken zumindest zum Teil gezielt derart geformt sind, dass sie bezüglich einer Haupterstreckungsebene der Hauptfläche schräg oder gekrümmt verlaufen. Das Lumineszenzkonversionsmaterial liegt besonders bevorzugt in Form einer im Wesentlichen ebenen Schicht vor, was sich mittels des angegebenen Verfahrens besonders gut und kontrolliert erzielen lässt. Die Schicht ist mit Vorteil im Wesentlichen eben ausgebildet.

Zusätzlich oder insbesondere auch alternativ ist mit Vorteil vorgesehen, dass das Lumineszenzkonversionsmaterial ein photostrukturierbares Material aufweist. Das Lumineszenzkonversionsmaterial ist in diesem Fall bevorzugt unmittelbar photostrukturiert.

Bevorzugt weist die Schicht Lumineszenzkonversionsmaterial eine Dicke zwischen einschließlich 5 µm und einschließlich 250 µm auf. Besonders bevorzugt beträgt die Dicke der Schicht zwischen einschließlich 10 µm und einschließlich 50 µm. Die Untergrenze der Schichtdicke kann jedoch auch mit Vorteil geringer als 10 µm oder sogar geringer als 5 µm sein.

Gemäß einer besonders zweckmäßigen Ausführungsform weist das Lumineszenzkonversionsmaterial mindestens eine Material aus der Gruppe bestehend aus Silikonen, Siloxanen, Spin-on Oxiden und photostrukturierbaren Materialien auf.

Mit Vorteil grenzt das Lumineszenzkonversionsmaterial seitlich an ein reflektierendes Material an. Neben beispielsweise der Form des Lumineszenzkonversionsmaterials erlaubt ein solches reflektierendes Material eine weitergehende vorteilhafte Beeinflussung der Abstrahlcharakteristik des Lumineszenzdiodenchips. Besonders bevorzugt weist das reflektierende Material ein photostrukturierbares Material auf. Alternativ oder zusätzlich kann das reflektierende Material auch weitere Materialien aufweisen, die in der Deckschicht enthalten sein können.

Der Lumineszenzdiodenchip ist besonders bevorzugt ein Dünnfilm-Lumineszenzdiodenchip. Ein Dünnfilm-Lumineszenzdiodenchip zeichnet sich insbesondere durch folgende charakteristische Merkmale aus:
- An einer zu einem Trägerelement hin gewandten ersten Hauptfläche einer strahlungserzeugenden Epitaxieschichtenfolge ist eine reflektierende Schicht aufgebracht oder ausgebildet, die zumindest einen Teil der in der Epitaxieschichtenfolge erzeugten elektromagnetischen Strahlung in diese zurückreflektiert;
- die Epitaxieschichtenfolge weist eine Dicke im Bereich von 20 µm oder weniger, insbesondere im Bereich von 10 µm auf; und
- die Epitaxieschichtenfolge enthält mindestens eine Halbleiterschicht mit zumindest einer Fläche, die eine Durchmischungsstruktur aufweist, die im Idealfall zu einer annähernd ergodischen Verteilung des Lichtes in der Epitaxieschichtenfolge führt, das heißt sie weist ein möglichst ergodisch stochastisches Streuverhalten auf.

Die Epitaxieschichtenfolge wird im Rahmen dieser Anmeldung auch Dünnfilm-Schicht genannt. Sie ist bevorzugt vollständig oder teilweise frei von einem Aufwachssubstrat. Ein Grundprinzip eines Dünnfilm-Lumineszenzdiodenchips ist beispielsweise in I. Schnitzer et al., Appl. Phys. Lett. 63 (16), 18. Oktober 1993, 2174-2176 beschrieben, deren Offenbarungsgehalt insofern hiermit durch Rückbezug aufgenommen wird.

Die Verwendung eines Dünnfilm-Lumineszenzdiodenchips führt zu einer besonders hohen Effektivität, da die von der Dünnfilm-Schicht emittierte und die elektromagnetische Strahlung in der Regel an den Leuchtstoffpartikeln gestreut wird und zu einem signifikanten Teil insbesondere auch in die Halbleiterschichtenfolge zurückgestreut wird. Bei einem Dünnfilm-Lumineszenzdiodenchip wird diese zurückgestreute Strahlung jedoch, verglichen mit anderen Systemen, mit geringeren Verlusten mittels der reflektierenden Schicht zurückreflektiert. Wegen der reflektierenden Schicht und der geringen Dicke der Epitaxieschichtenfolge sind somit Absorptionsverluste relativ gering.

Eine weitere erfindungsgemäße Ausführungsform des Lumineszenzdiodenchips sieht mit Vorteil vor, dass das Lumineszenzkonversionsmaterial mindestens einen organischen Leuchtstoff und/oder mindestens einen Leuchtstoff aufweist, der zumindest teilweise in Form von Nanopartikeln vorliegt. Die Nanopartikel weisen bevorzugt einen Mediandurchmesser d₅₀ von kleiner als oder gleich 100 nm auf, wobei der Mediandurchmesser anhand einer Volumen- oder Massenverteilungssumme (Q₃) ermittelt wird. Besonders bevorzugt weisen die Nanopartikel einen d₅₀-Wert, gemessen in Q₃, von kleiner als oder gleich 30 nm und größer als oder gleich 1 nm auf.

Verglichen mit herkömmlichen Leuchtstoffpartikeln, die in lichtemittierenden optischen Bauelementen verwendet werden, kann mit Leuchtstoffpartikeln in Form von Nanopartikeln ein verbessertes homogenes Leuchtbild realisiert werden. Organische Leuchtstoffe und Leuchtstoffe in Form von Nanopartikeln lassen sich besonders gut und dauerhaft in flüssigen, insbesondere in zähflüssigen Matrixmaterialien dispergieren. Dadurch ist es zum Beispiel möglich, eine Konzentrierung von Leuchtstoff in äußeren Bereichen des Grundkörpers bei Einwirkung von Zentrifugalkraft deutlich zu reduzieren. Dies ermöglicht es, das Lumineszenzkonversionsmaterial mittels eines Spin-Coating Verfahrens aufzubringen.

Weitere Vorteile, bevorzugte Ausführungsformen und Weiterbildungen der Verfahren und des Lumineszenzdiodenchips ergeben sich aus den im Folgenden in Verbindung mit den Figuren 1 bis 20 erläuterten Ausführungsbeispielen. Es zeigen:
Figuren 1 bis 11 schematische Schnittansichten eines Grundkörpers bei verschiedenen Verfahrensstadien eines Ausführungsbeispiels des Verfahrens,
Figuren 12 und 13 schematische Schnittansichten eines Grundkörpers bei verschiedenen Verfahrensstadien eines zweiten Ausführungsbeispiels des Verfahrens,
Figuren 14 und 15 schematische Schnittansichten eines Grundkörpers bei verschiedenen Verfahrensstadien eines dritten Ausführungsbeispiels des Verfahrens,
Figur 16 eine schematische Schnittansicht eines Ausführungsbeispiels des Lumineszenzdiodenchips, und
Figuren 17 bis 20 mikroskopische Aufnahmen verschiedener Verfahrensstadien bei einem real durchgeführten Ausführungsbeispiel des Verfahrens.

In den Ausführungsbeispielen und Figuren sind gleiche oder gleich wirkende Bestandteile jeweils mit den gleichen Bezugszeichen versehen. Die dargestellten Bestandteile sowie die Größenverhältnisse der Bestandteile untereinander sind nicht notwendigerweise als maßstabsgerecht anzusehen. Vielmehr können einige Details der Figuren zum besseren Verständnis übertrieben groß dargestellt sein.

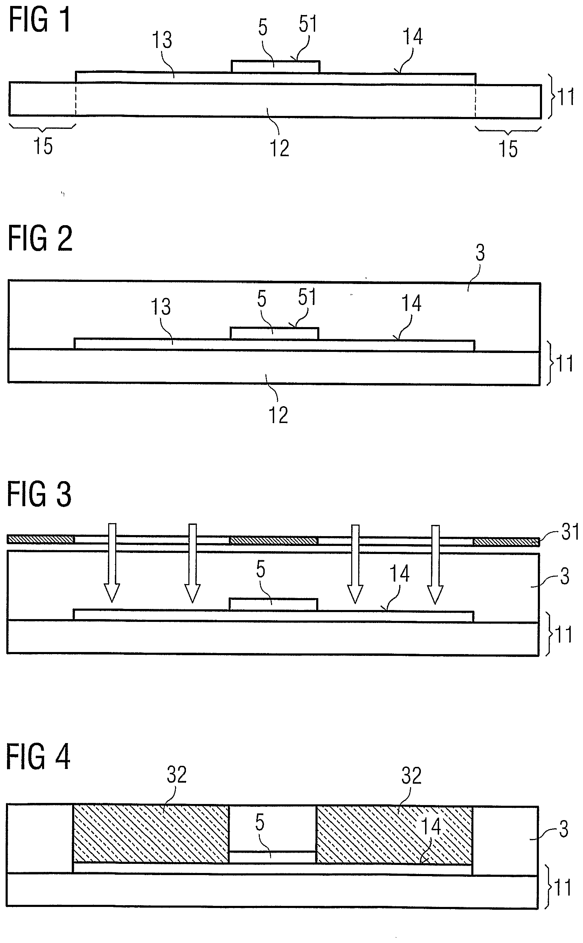

In Figur 1 ist ein Grundkörper 11 dargestellt. Dieser weist einen Träger 12, eine auf dem Träger aufgebrachte Dünnfilm-Schicht 13 sowie ein Bondpad 5 auf, das auf der dem Träger 12 gegenüberliegenden Seite der Dünnfilm-Schicht 13 aufgebracht ist. Die freie Außenfläche des Bondpads 5 bildet eine elektrische Kontaktfläche 51 zum elektrischen Anschließen einer Struktur für einen Lumineszenzdiodenchip des Grundkörpers.

Die Dünnfilmschicht 13 basiert beispielsweise auf Nitrid-Verbindungshalbleitermaterialien und ist geeignet, eine elektromagnetische Strahlung aus dem blauen und/oder ultravioletten Spektrum zu emittieren. Nitrid-Verbindungshalbleitermaterialien sind Verbindungshalbleitermaterialien, die Stickstoff enthalten, wie Materialien aus dem System InₓAl_{y}Ga_{1-x-y}N mit 0 ≤ x ≤ 1, 0 ≤ y ≤ 1 und x + y ≤ 1. Die Dünnfilmschicht weist z.B. mindestens eine Halbleiterschicht aus einem Nitrid-Verbindungshalbleitermaterial auf.

In der Dünnfilmschicht 13 kann beispielsweise ein herkömmlicher pn-Übergang, eine Doppelheterostruktur, eine Einfach-Quantentopfstruktur (SQW-Struktur) oder eine Mehrfach-Quantentopfstruktur (MQW-Strukur) enthalten sein. Solche Strukturen sind dem Fachmann bekannt und werden von daher an dieser Stelle nicht näher erläutert. Beispiele für solche MQW-Strukturen sind in den Druckschriften US 5,831,277 und US 5,684,309 beschrieben, deren Offenbarungsgehalt insofern hiermit durch Rückbezug aufgenommen wird.

Zwischen der Dünnfilm-Schicht 13 und dem Träger 12 ist ein Reflektor angeordnet, der für elektromagnetische Strahlung, die in der Dünnfilm-Schicht erzeugbar ist, reflektierend ist. Der Reflektor ist nicht dargestellt. Es kann sich hierbei beispielsweise um einen metallischen oder dielektrischen Spiegel handeln. Bevorzugt umfasst der Reflektor eine dielektrische Schicht und eine auf dieser dielektrischen Schicht aufgebrachte metallische Schicht, wobei die dielektrische Schicht an die Dünnfilm-Schicht 13 angrenzt.

Auf eine Hauptfläche 14 des Grundkörpers 11 wird eine Deckschicht 3 aufgebracht, siehe Figur 2. Die Deckschicht 3 besteht beispielsweise aus einem photostrukturierbaren Material, was ein photostrukturierbarer Lack oder ein photostrukturierbares Harz sein kann. Es wird z.B. mittels eines Spin-Coating Verfahrens in einer ebenen Schicht aufgebracht. Über der Dünnfilm-Schicht 13 weist die Deckschicht 3 beispielsweise eine Dicke von etwa 40 µm auf, welche über dem Bondpad 5 entsprechend etwas geringer und über dem Träger 12 etwas größer ist.

Bei dem photostrukturierbaren Material müssen zum Photostrukturieren die zu entfernenden Teile belichtet werden. Selbstverständlich ist es auch möglich alternativ ein photostrukturierbares Material zu verwenden, bei dem die nicht zu entfernenden Teile beim Photostrukturieren zu belichten sind. Es können grundsätzlich auch unterschiedliche photostrukturierbare Materialien miteinander kombiniert werden.

Nachfolgend wird die Deckschicht 3 in Bereichen über der Dünnfilm-Schicht 14, außer in dem Bereich oberhalb des Bondpads, mittels einer Maske 31 und elektromagnetischer Strahlung einer geeigneten Wellenlänge belichtet, siehe Figur 3. Die elektromagnetische Strahlung ist in Figur 3 durch Pfeile symbolisch dargestellt.

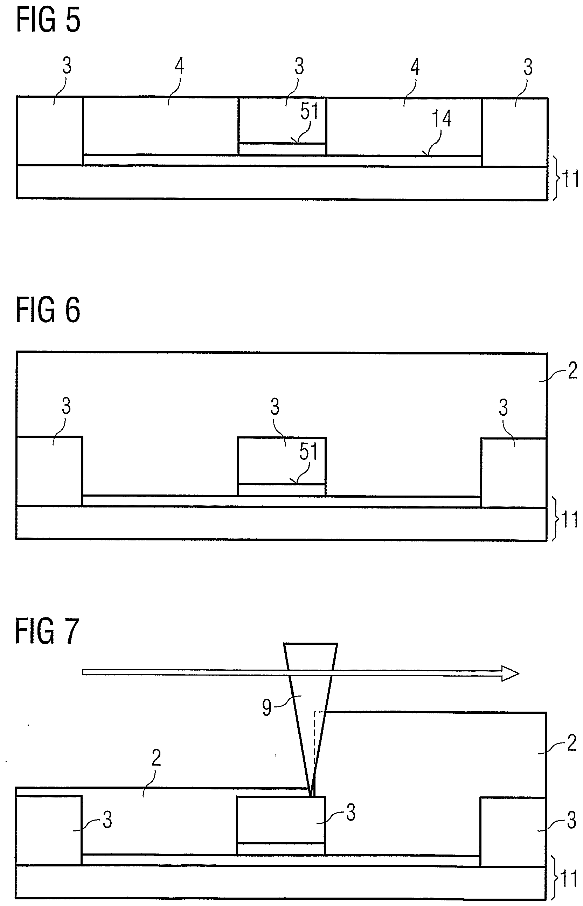

In einem weiteren Verfahrensschritt wird die belichtete Deckschicht 3 mittels eines für das photostrukturierbare Material geeigneten Mediums entwickelt. In Figur 4 sind die belichteten und entwickelten Teile 32 der Deckschicht 3 schematisch dargestellt. Nachfolgend werden die belichteten Teile 32 der Deckschicht 3 entfernt, so dass mindestens eine Kavität 4 ausgebildet wird, siehe Figur 5.

Wie in Figur 6 dargestellt wird in einem weiteren Verfahrensschritt Lumineszenzkonversionsmaterial auf den Grundkörper 11 aufgebracht, so dass die Kavität 4 beispielsweise vollständig von diesem gefüllt ist. In einem weiteren Verfahrensschritt wird überschüssiges Lumineszenzkonversionsmaterial 2 mittels Abstreifen entfernt. Dies kann beispielsweise mittels einer Klinge 9 erfolgen, die über die Deckschicht 3 gezogen wird, so dass überschüssiges Lumineszenzkonversionsmaterial 2 von der Deckschicht 3 abgezogen wird, was in Figur 7 schematisch dargestellt ist. Zum Abstreifen wird beispielsweise eine scharfe Metallklinge verwendet.

Das Lumineszenzkonversionsmaterial weist ein flüssiges, insbesondere ein zähflüssige Matrixmaterial auf, das gehärtet werden kann. Bei dem vorliegenden Ausführungsbeispiel wird ein additionsvernetzendes Silikon verwendet, das bevorzugt thermisch härtend ist. Als Matrixmaterial eignet sich alternativ z.B. auch ein Spin-On Oxid oder ein Siloxan.

Nach dem Abstreifen des überschüssigen Lumineszenzkonversionsmaterials 2 wird der Grundkörper 11 mit den aufgebrachten Materialien ausgeheizt. Dies erfolgt zum Beispiel mittels einer heißen Platte oder warmer Umluft bei etwa 100 °C für eine Dauer von beispielsweise 2 Stunden. Bei einem derartigen Ausheizen wird das Matrixmaterial des Lumineszenzkonversionsmaterials 2 angehärtet.

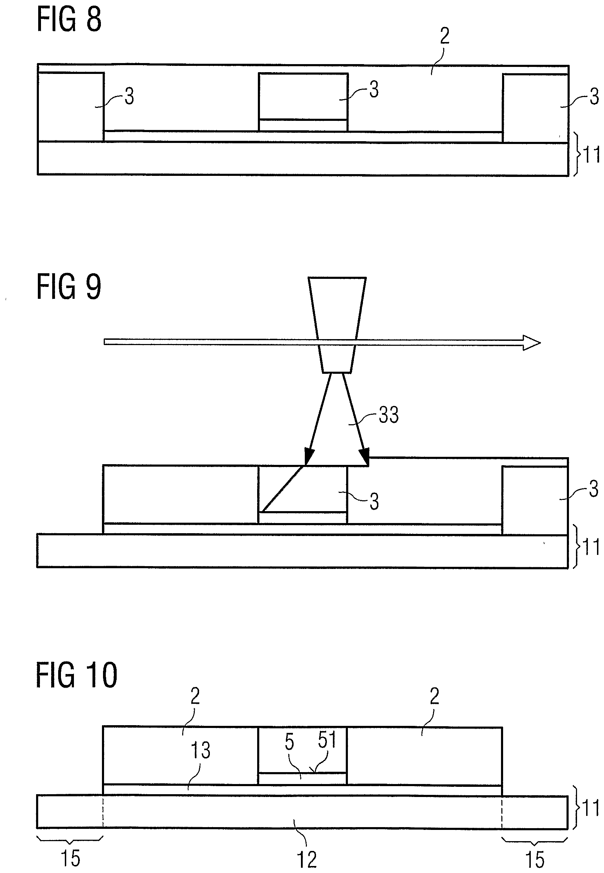

Wie in Figur 8 dargestellt, wird das Lumineszenzkonversionsmaterial 2 bei dem Ausführungsbeispiel durch das Abstreifen nicht vollständig von der Deckschicht 3 entfernt, sondern es verbleibt ein dünner Film von Lumineszenzkonversionsmaterial 2 auf dem Deckschichtmaterial 3. In einem nachfolgenden Verfahrensschritt, der in Figur 9 schematisch dargestellt ist, wird das verbliebene Material der Deckschicht 3 sowie der dünne Film von Lumineszenzkonversionsmaterial 2 abgelöst. Dies erfolgt beispielsweise mittels eines so genannten Liftoff Prozesses, bei dem der dünne Film an Lumineszenzkonversionsmaterial 2 durch Entfernen des Materials der Deckschicht 3 abgehoben wird.

Zum Entfernen dieser Materialien wird die über der Deckschicht befindliche dünne Schicht Lumineszenzkonversionsmaterial zunächst aufgebrochen, was beispielsweise mechanisch mittels eines Hochdruckfächerstrahles 33 erfolgt, siehe Figur 9. Dieser Hochdruckfächerstrahl 33 kann zudem auch dazu benutzt werden, das restliche Material der Deckschicht 3 zu entfernen. Als Medium für den Hochdruckfächerstrahl 33 kann beispielsweise Wasser verwendet werden. Zusätzlich oder alternativ wird als Medium für den Hochdruckfächerstrahl 33 beispielsweise N-Methyl-2-Pyrrolidon (NMP) verwendet.

Nach dem Entfernen der Deckschicht 3 und des auf der Deckschicht befindlichen dünnen Films an Lumineszenzkonversionsmaterial verbleibt eine strukturierte Schicht von Lumineszenzkonversionsmaterial 2 auf dem Grundkörper 11, was in Figur 10 dargestellt ist. Durch das Entfernen der Deckschicht 3 werden insbesondere auch elektrische Kontaktflächen 51 des Bondpads 5 sowie beispielsweise Durchtrenn-Bereiche 15 freigelegt. In den Durchtrenn-Bereichen 15 wird der Grundkörper nachfolgend beispielsweise mittels Sägen durchtrennt, um eine Mehrzahl von Lumineszenzdiodenchips 1 herzustellen. Obwohl in Figur 10 nur eine einzige Struktur für einen Lumineszenzdiodenchip mit einem einzigen Bondpad 5 und einer einzigen Dünnfilm-Schicht 13 dargestellt ist, kann der Grundkörper 11 beispielsweise eine Mehrzahl derartiger Strukturen aufweisen, die sich in dem Grundkörper in einem gemeinsamen Verbund miteinander befinden. Zudem können für einen Lumineszenzdiodenchip auch zwei Bondpads vorgesehen sein. Die Lumineszenzdiodenchips werden beispielsweise mittels Sägen oder Laserstrahlen aus dem gemeinsamen Verbund vereinzelt. Bei dem Verbund handelt es sich z.B. um einen Wafer.

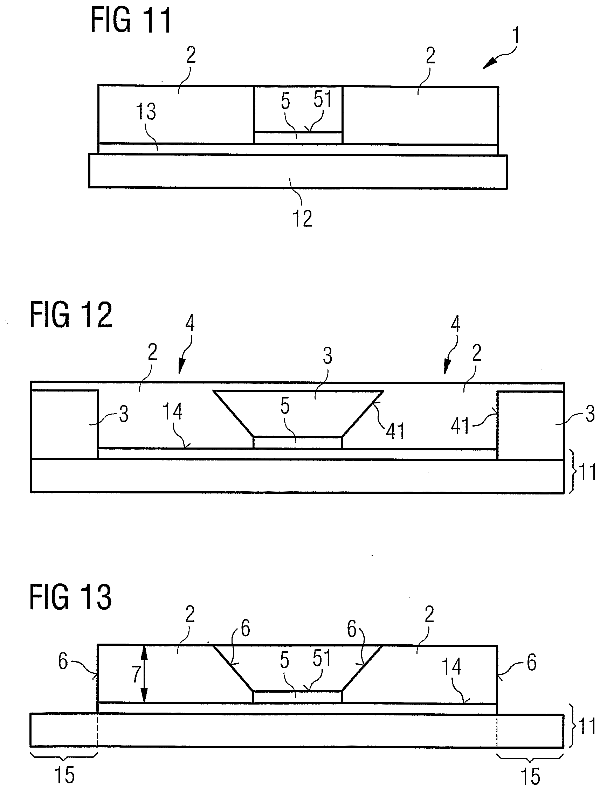

Ein fertiger Lumineszenzdiodenchip 1, der mit Lumineszenzkonversionsmaterial 2 versehen ist, ist in Figur 11 dargestellt. Er ist geeignet, um beispielsweise in ein Lumineszenzdiodenbauelement oder ein Modul eingebaut zu werden, was seine elektrische und mechanische Montage umfasst. Zur Fertigstellung des Lumineszenzdiodenchips kann es erforderlich sein, das Lumineszenzkonversionsmaterial durch ein weiteres Heizen auszuhärten. Dies erfolgt beispielsweise wiederum mittels einer heißen Platte oder warmer Umluft beispielsweise bei 150 °C für etwa 1 Stunde.

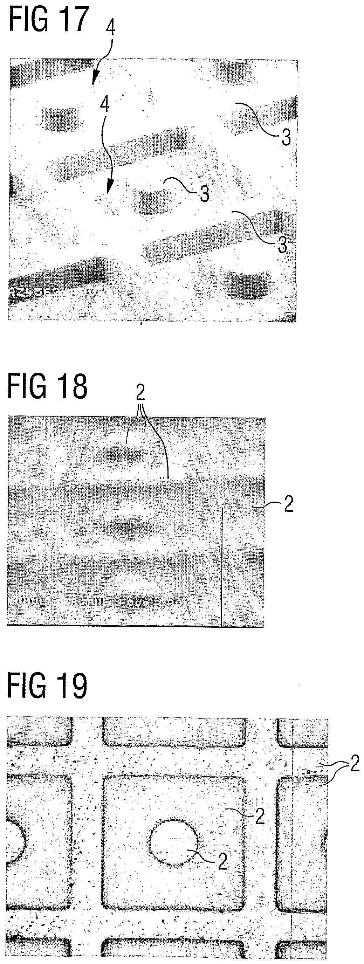

In den Figuren 17 bis 20 sind mikroskopische Aufnahmen verschiedener Verfahrensstadien eines real durchgeführten Verfahrens dargestellt. Das Verfahren ähnelt dem vorhergehend anhand der Figuren 1 bis 11 erläuterten Verfahren.

Der Grundkörper 11 ist beispielsweise ein Wafer, auf dem eine Mehrzahl von Dünnfilm-Schichten 13 für eine Mehrzahl von Lumineszenzdiodenchips aufgebracht sind. Alternativ kann auch eine einzige Dünnfilm-Schicht auf dem Wafer aufgebracht sein, die für eine Mehrzahl von Lumineszenzdiodenchips vorgesehen und noch nicht strukturiert ist. Als Alternative zu einem Wafer eignen sich auch andere Träger wie beispielsweise Trägerfolien oder Metallträger. In den Figuren 17 bis 20 ist jeweils ein Ausschnitt des Trägers dargestellt.

Figur 17 entspricht etwa dem in Figur 5 dargestellten Verfahrensstadium. In diesem ist eine Deckschicht 3 auf dem Grundkörper 11 aufgebracht und mit einer Mehrzahl von Kavitäten 4 versehen. Die runden Teile der Deckschicht 3, die in Figur 17 erkennbar sind, sind über entsprechend rund geformten Bondpads des Grundkörpers angeordnet. Dahingegen sind die rahmenartig ausgebildeten Teile der Deckschicht 3 über Bereichen des Grundkörpers angeordnet, innerhalb derer der Grundkörper durchtrennt werden soll.

Die in Figur 18 dargestellte mikroskopische Aufnahme entspricht in etwa dem in Figur 6 dargestellten Verfahrensstadium. Auf den Grundkörper 11 ist ein Lumineszenzkonversionsmaterial 2 in Form einer zähflüssigen, härtbaren Masse aufgebracht worden, welche die Kavitäten 4 füllt.

Die in Figur 19 dargestellte Aufnahme entspricht dem vorhergehend anhand von Figur 8 erläuterten Verfahrensstadium. Überschüssiges Lumineszenzkonversionsmaterial 2 ist mittels einer Klinge 9 abgestriffen und der Grundkörper 11 ist ausgeheizt. In der Aufnahme lässt sich deutlich erkennen, in welchen Bereichen Teile der Deckschicht und in welchen nur Lumineszenzkonversionsmaterial 2 auf den Grundkörper angeordnet sind. Allerdings sind auch die Teile der Deckschicht mit einem dünnen Film von Lumineszenzkonversionsmaterial 2 bedeckt.

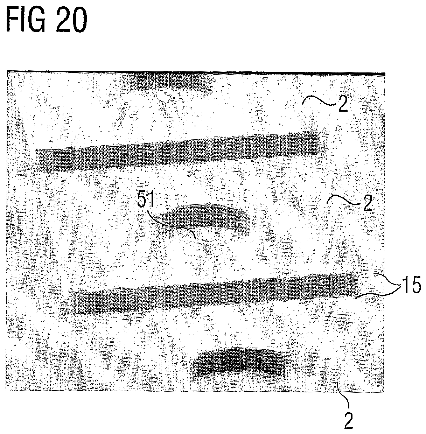

Dieser dünne Film und die verbliebenen Teile der Deckschicht 3 werden nachfolgend entfernt. Figur 20 zeigt das vorhergehend anhand Figur 10 erläuterte Verfahrensstadium, in dem eine wohl definiert strukturierte Lumineszenzkonversionsschicht 2 auf dem Grundkörper verbleibt. Elektrische Kontaktflächen 51 der Bondpads sowie Bereiche 15, die beispielsweise für Sägespuren vorgesehen sind, sind in diesem Verfahrensstadium freigelegt. Der Grundkörper 11 kann in dieser Form zu einer Vielzahl von Lumineszenzdiodenchips 1 vereinzelt werden.

Bei allen beschriebenen Ausführungsbeispielen ist es gemäß einer vorteilhaften Ausführungsform möglich, den Träger 12 nach dem Aufbringen des Lumineszenzkonversionsmaterials 2 abzulösen. Besonders bevorzugt erfolgt dies nach dem Aushärten des Lumineszenzkonversionsmaterials 2. Gemäß diesen Ausführungsbeispiels stabilisiert das Lumineszenzkonversionsmaterial 2 die fagile Dünnfilm-Schicht 13, so dass mit Vorteil auf den Träger verzichtet werden kann. Dies ermöglicht es, besonders flache Lumineszenzdiodenchips herzustellen, die mit einem Lumineszenzkonversionsmaterial 2 versehen sind.

Der Lumineszenzdiodenchip ist gemäß diesen Ausführungsbeispiels frei von einem Träger. Bevorzugt weist er eine epitaktische Halbleiterschichtenfolge auf, die geeignet ist, eine elektromagnetische Strahlung zu emittieren. Besonders bevorzugt ist die epitaktische Halbleiterschichtenfolge frei von einem Aufwachssubstrat. Der für das Verfahren verwendete Träger 12 kann beispielsweise eine flexible Trägerfolie sein, an der die Dünnfilm-Schichten 13 haften.

In Figur 12 ist ein Verfahrensstadium eines weiteren Ausführungsbeispiels für ein Verfahren zum Herstellen eines Lumineszenzdiodenchips dargestellt. In diesem Verfahrensstadium ist auf einem Grundkörper 11 bereits eine Deckschicht 3 aufgebracht und mit Kavitäten 4 versehen. Zudem sind die Kavitäten 4 in dem dargestellten Verfahrensstadium mit einem Lumineszenzkonversionsmaterial 2 gefüllt.

Im Unterschied zu den vorhergehend erläuterten Ausführungsbeispielen werden die Kavitäten 4 bei dem in den Figuren 12 und 13 dargestellten Ausführungsbeispiel derart eingebracht, dass ihr Querschnitt mit zunehmender Tiefe größer wird. Auf der dem Bondpad 5 zugewandten Seite verlaufen die Innenwände der Kavität bezüglich einer Haupterstreckungsebene der Hauptfläche 14 schräg vom Bondpad 5 weg.

Entsprechend liegt das Lumineszenzkonversionsmaterial 2 nach Entfernen der Deckschicht 3 in Form einer Schicht vor, deren zu dem Bondpad 5 gewandten Seitenflanken 6 bezüglich einer Haupterstreckungsebene der Hauptfläche 14 zumindest teilweise schräg verlaufen. Dieser zum Teil schräger Verlauf der Seitenflanken 6 der Schicht Lumineszenzkonversionsmaterial 2 hat bei dem in Figur 13 dargestellten Ausführungsbeispiel insbesondere den Vorteil, dass das Bondpad 5 und somit die elektrische Kontaktfläche 51 verbessert von außen zugänglich ist, um z.B. mit einem Bonddraht elektrisch leitend kontaktiert zu werden.

Verglichen mit einem Lumineszenzkonversionsmaterial 2, dessen Seitenflanken 6 ausschließlich senkrecht zu einer Haupterstreckungsebene 14 des Grundkörpers 11 verlaufen, können derart schräge Seitenflanken des Lumineszenzkonversionsmaterials 2 zusätzlich eine verbesserte Auskopplung von elektromagnetischer Strahlung aus dem Lumineszenzkonversionsmaterial 2 bewirken.

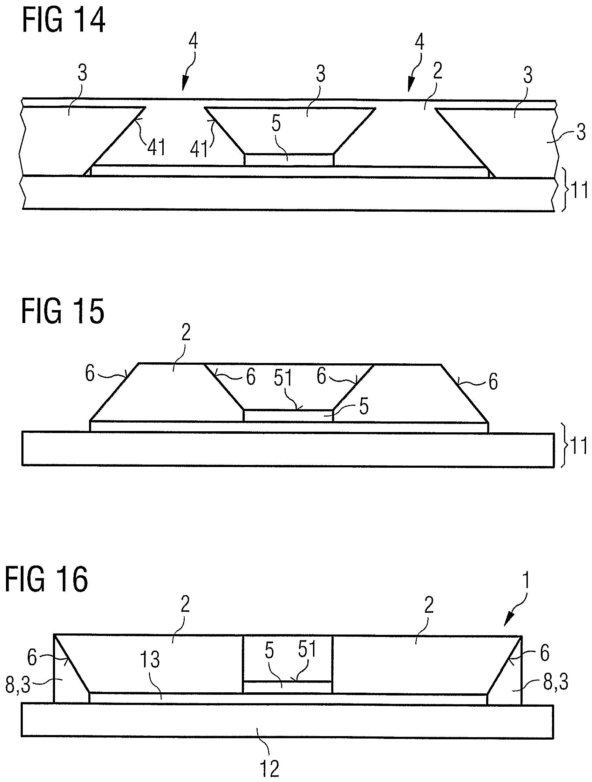

Zusätzlich oder alternativ können die Seitenflanken 6 auch zumindest teilweise gekrümmt verlaufen. Weiterhin ist es auch möglich, dass auch die von dem Bondpad 5 abgewandten Seitenflanken 6 des Lumineszenzkonversionsmaterials 2 schräg oder gekrümmt bezüglich der Haupterstreckungsebene verlaufen, wie das in den Figuren 14 und 15 dargestellt ist. Eine derartige Ausformung der Schicht Lumineszenzkonversionsmaterial 2 ist für eine Auskopplung von elektromagnetischer Strahlung besonders vorteilhaft.

Zur Herstellung der Kavitäten 4 wird bei den in den Figuren 12 und 14 dargestellten Ausführungsbeispielen beispielsweise ein photostrukturierbares Material für die Deckschicht 3 verwendet, dessen Photostrukturierung ein Bestrahlen der nicht zu entfernenden Teile der Deckschicht 3 mit elektromagnetischer Strahlung umfasst. Dadurch können die schräg verlaufenden Innenwände der Kavitäten 4 beispielsweise mittels einer Graustufenmaske erzeugt werden.

Mittels der Graustufenmaske kann bewerkstelligt werden, dass die Deckschicht in den Bereichen, in denen schräge Innenwände auszubilden sind, nicht vollständig und bis zu einer sich gleichmäßig ändernden Tiefe bestrahlt wird. Ebenso können auch Krümmungen erzeugt werden, bei denen es erforderlich ist, dass sich die durchstrahlte Tiefe der Deckschicht nicht gleichmäßig, sondern entsprechend der Krümmung ungleichmäßig im Verlauf entlang der Haupterstreckungsebene des Grundkörpers 11 ändert.

Auf analoge Weise lassen sich auch Kavitäten erzeugen, deren Querschnitt sich mit zunehmender Tiefe verkleinert. Im Unterschied zu den anhand Figuren 12 und 14 erläuterten Ausführungsbeispielen wird hierfür jedoch zweckmäßiger Weise ein photostrukturierbares Material verwendet, bei dem die zu entfernenden Teile zum Photostrukturieren belichtet werden müssen.

Als Alternative oder Ergänzung zu den vorhergehend beschriebenen Ausführungsbeispielen für das Verfahren ist es möglich, ein photostrukturierbares Material mit mindestens einem Leuchtstoff zu versetzen und als ein Lumineszenzkonversionsmaterial auszubilden. Dies bietet mit besonderem Vorteil die Möglichkeit, das Lumineszenzkonversionsmaterial unmittelbar durch die Verwendung von Photostrukturierung präzise zu formen.

Als Materixmaterial wird hierfür beispielsweise ein photostrukturierbares Glas verwendet. Dieses basiert zum Beispiel auf den Grundgläsern des Dreistoffsystems Li₂O-Al₂O₃-SiO₂ und ist mit mindestens einem der Stoffe Ag₂O, CeO₂, Sb₂O₃ und SnO dotiert. Zum Photostrukturieren wird das photostrukturierbare Glas beispielsweise mit UV-Licht mit einer Wellenlänge zwischen einschließlich 290 nm und einschließlich 330 nm belichtet. Gläser, die mit elektromagnetischer Strahlung aus diesem Wellenlängenbereich photostrukturierbar sind, sind kommerziell erhältlich.

Alternativ kann als photostrukturierbares Matrixmaterial ein additionsvernetzendes Silikon verwendet werden, das mittels UV-Strahlung oder sichtbarem Licht aushärtbar ist. Auch derartige Silikone sind kommerziell erhältlich. Beim Photostrukturieren werden die Teile, die bestehen bleiben sollen, durch Bestrahlung mit elektromagnetischer Strahlung eines geeigneten Wellenlängenbereiches ausgehärtet. Nachfolgend wird nicht ausgehärteter Silikon mittels eines Lösungsmittels, das aromatische Gruppen enthält, selektiv entfernt.

Alternativ zu dem additionsvernetzenden Silikon können auch Spin-On Gläser verwendet werden, die Polysiloxanketten als Basiseinheiten enthalten und mit UV-Strahlung oder sichtbarem Licht vernetzt werden können.

Bei der Verwendung eines derart unmittelbar strukturierbaren Lumineszenzkonversionsmaterials werden in die Deckschicht zweckmäßiger Weise dort Kavitäten eingebracht, wo kein Lumineszenzkonversionsmaterial erwünscht ist. Es ist jedoch auch möglich, verschiedene Arten von Lumineszenzkonversionsmaterial miteinander zu kombinieren, so dass sowohl die Deckschicht als auch ein weiteres Lumineszenzkonversionsmaterial, das in Kavitäten der Deckschicht eingebracht werden kann, mindestens einen Leuchtstoff aufweist.

In dem photostrukturierbaren Matrixmaterial ist bevorzugt mindestens ein Leuchtstoff enthalten, der in Form von Nanopartikeln und/oder in Form eines organischen Leuchtstoffes vorliegt. Derartige Leuchtstoffe sind jedoch auch in Verbindung mit anderen Matrixmaterialien verwendbar.

Beispielsweise wird ein Leuchtstoff verwendet, dessen Partikel einen Mediandurchmesser d₅₀ von kleiner als oder gleich 30 nm, beispielsweise von 25 nm aufweist, wobei der Mediandurchmesser anhand einer Volumen- oder Massenverteilungssumme (Q₃) ermittelt wird.

Grundsätzlich eignen sich alle für die Anwendung bei LEDs bekannten Leuchtstoffe für die Verwendung im Lumineszenzkonversionsmaterial. Beispiele für derartige als Konverter geeignete Leuchtstoffe und Leuchtstoffmischungen sind:
- Chlorosilikate, wie beispielsweise in DE 10036940 und dem dort beschriebenen Stand der Technik offenbart,
- Orthosilikate, Sulfide, Thiometalle und Vanadate wie beispielsweise in WO 2000/33390 und dem dort beschriebenen Stand der Technik offenbart,
- Aluminate, Oxide, Halophosphate, wie beispielsweise in US 6,616,862 und dem dort beschriebenen Stand der Technik offenbart,
- Nitride, Sione und Sialone wie beispielsweise in DE 10147040 und dem dort beschriebenen Stand der Technik offenbart, und
- Granate der Seltenen Erden wie YAG:Ce und der Erdalkalielemente wie beispielsweise in US 2004-062699 und dem dort beschriebenen Stand der Technik offenbart.

Bei den in Figur 16 dargestellten Ausführungsbeispiel eines Lumineszenzdiodenchips 1 ist die Deckschicht 3 nicht vollständig entfernt, sondern Teile der Deckschicht 3 grenzen außen seitlich an das Lumineszenzkonversionsmaterial 2 an. Zumindest dieser Teil der Deckschicht 3 besteht beispielsweise aus einem Material, das für die von dem Lumineszenzdiodenchip emittierte elektromagnetische Strahlung reflektierend ist. Somit bilden die verbleibenden Teile der Deckschicht 3 einen Reflektor.

Alternativ lassen sich strahlungsdurchlässige Materialien verwenden, die mit reflektierenden Füllstoffen versetzt sind. Als Materialien für den Füllstoff eignen sich z.B. Titandioxid oder Bariumsulfat, die in Form eines Pulvers vorliegen. Ein geeignetes strahlungsdurchlässiges Material ist z.B. ein additionsvernetzenden Silikon oder Spin-On Glas. Damit diese trotz des Füllstoffes mit elektromagnetischer Strahlung aushärtbar sind, müssen sie zusätzlich mit Photoinitiatoren versetzt sein, die bei geeigneter Bestrahlung eine Aushärtung aktivieren.

Da die elektromagnetische Strahlung in dem Lumineszenzkonversionsmaterial 2 in der Regel teilweise stark gestreut wird, hat das Lumineszenzkonversionsmaterial 2 ein diffuses Abstrahlverhalten. Mittels des reflektierenden Materials 8 kann ein Teil der elektromagnetischen Strahlung in eine Vorzugsrichtung abgelenkt werden.

Hierzu sind die zum Lumineszenzkonversionsmaterial 2 gewandten Wände des reflektierenden Materials beispielsweise schräg bezüglich einer Haupterstreckungsebene der Hauptfläche ausgebildet. Das angrenzende Lumineszenzkonversionsmaterial 2 weist an dieser Seitenflanke entsprechend die gleiche Schräge auf. Diese Struktur wird z.B. mittels Kavitäten hergestellt, deren Querschnitt mit zunehmender Tiefe kleiner wird.

Die Erfindung ist nicht durch ihre Beschreibung anhand der Ausführungsbeispiele auf diese beschränkt. Vielmehr umfasst die Erfindung jedes neue Merkmal sowie jede Kombination von Merkmalen, was insbesondere jede Kombination von Merkmalen in den Patentansprüchen beinhaltet, auch wenn dieses Merkmal oder diese Kombination selbst nicht explizit in den Patentansprüchen oder Ausführungsbeispielen angegeben ist.

## Patentansprüche

1. Verfahren zum Herstellen mindestens eines Lumineszenzdiodenchips, der mit einem Lumineszenzkonversionsmaterial versehen ist, das mindestens einen Leuchtstoff aufweist, mit den Schritten:
- Bereitstellen eines Grundkörpers, der eine Schichtenfolge für den Lumineszenzdiodenchip aufweist, die geeignet ist, eine elektromagnetische Strahlung zu emittieren;
- Aufbringen einer Deckschicht auf zumindest eine Hauptfläche des Grundkörpers;
- Einbringen von mindestens einer Kavität in die Deckschicht; und
- Aufbringen von Lumineszenzkonversionsmaterial auf den Grundkörper, derart, dass die Kavität vollständig oder teilweise gefüllt wird, wobei nur ein Teil der Deckschicht nach dem Aufbringen des Lumineszenzkonversionsmaterials selektiv entfernt wird.

2. Verfahren nach Anspruch 1,
wobei die Deckschicht ein photostrukturierbares Material und/oder ein reflektierendes Material aufweist.

3. Verfahren nach Anspruch 1 oder 2,
wobei das Entfernen mechanisch und/oder chemisch erfolgt.

4. Verfahren nach Anspruch 1 oder 2,
wobei neben dem Lumineszenzkonversionsmaterial zumindest auch die Deckschicht mindestens einen Leuchtstoff aufweist.

5. Verfahren nach einem der vorhergehenden Ansprüche,
wobei der Grundkörper auf der Hauptfläche mindestens eine elektrische Kontaktfläche zum elektrischen Anschließen des mindestens einen Lumineszenzdiodenchips aufweist und die Kavität lateral versetzt zu der Kontaktfläche der Deckschicht eingebracht wird.

6. Verfahren nach einem der vorhergehenden Ansprüche,
wobei das Lumineszenzkonversionsmaterial mindestens ein Material aus der Gruppe bestehend aus Silikonen, Siloxanen, Spin-On Oxiden und photostrukturierbaren Materialien aufweist.

7. Verfahren nach einem der vorhergehenden Ansprüche,
wobei das Lumineszenzkonversionsmaterial in Form eines flüssigen, härtbaren Stoffes aufgebracht und nachfolgend gehärtet wird.

8. Verfahren nach Anspruch 7,
wobei überschüssiges Lumineszenzkonversionsmaterial vor dem Härten zumindest teilweise durch Abstreifen entfernt wird.

9. Verfahren zum Herstellen mindestens eines Lumineszenzdiodenchips, der mit einem Lumineszenzkonversionsmaterial versehen ist, das mindestens einen Leuchtstoff aufweist, mit den Schritten:
- Bereitstellen eines Grundkörpers, der eine Schichtenfolge für den Lumineszenzdiodenchip aufweist die geeignet ist, eine elektromagnetische Strahlung zu emittieren;
- Aufbringen einer photostrukturierbaren Deckschicht, die den Leuchtstoff aufweist, auf zumindest eine Hauptfläche des Grundkörpers; und
- Einbringen von mindestens einer Kavität in die Deckschicht, wobei die Deckschicht photostrukturierbar ist und ein Verlauf des Querschnitts oder der Innenwände der Kavität zumindest teilweise durch ungleichmäßig starkes Belichten derart eingestellt wird, dass
- ihr Querschnitt mit zunehmender Tiefe größer oder kleiner wird, oder
- ihre Innenwände zumindest zum Teil bezüglich einer Haupterstreckungsebene der Hauptfläche schräg oder gekrümmt verlaufen.

10. Verfahren nach einem der vorhergehenden Ansprüche, wobei der Grundkörper für eine Mehrzahl von Lumineszenzdiodenchips vorgesehen ist.

11. Verfahren nach einem der vorhergehenden Ansprüche, wobei der Grundkörper ein Wafer oder ein Träger, auf dem die Schichtenfolge oder mehrere derartiger Schichtenfolgen aufgebracht sind, ist.

12. Lumineszenzdiodenchip mit einem Grundkörper, der geeignet ist, elektromagnetische Strahlung zu emittieren und der auf zumindest einer Hauptfläche mit einem Lumineszenzkonversionsmaterial versehen ist, das mindestens einen Leuchtstoff aufweist, und das Lumineszenzkonversionsmaterial als eine Schicht vorliegt, deren Seitenflanken zumindest zum Teil gezielt derart geformt sind, dass sie bezüglich einer Haupterstreckungsebene der Hauptfläche schräg oder gekrümmt verlaufen,
**dadurch gekennzeichnet, dass**
- das Lumineszenzkonversionsmaterial seitlich an ein reflektierendes Material angrenzt, welches ein photostrukturierbares Material aufweist; oder
- das Lumineszenzkonversionsmaterial mindestens einen Leuchtstoff aufweist, der zumindest teilweise in Form von Nanopartikeln vorliegt.

13. Lumineszenzdiodenchip nach Anspruch 12,
das Lumineszenzkonversionsmaterial mindestens ein Material aus der Gruppe bestehend aus Silikonen, Siloxanen, Spin-On Oxiden und photostrukturierbaren Materialien aufweist.

14. Lumineszenzdiodenchip mit einem Grundkörper, der geeignet ist, elektromagnetische Strahlung zu emittieren und der auf zumindest einer Hauptfläche mit einem Lumineszenzkonversionsmaterial versehen ist, das mindestens einen Leuchtstoff aufweist,
**dadurch gekennzeichnet, dass**
- das Lumineszenzkonversionsmaterial ein photostrukturierbares Material aufweist, und
- das Lumineszenzkonversionsmaterial mindestens einen Leuchtstoff aufweist, der zumindest teilweise in Form von Nanopartikeln vorliegt.

15. Lumineszenzdiodenchip nach Anspruch 14,
bei dem das Lumineszenzkonversionsmaterial photostrukturiert ist.

16. Lumineszenzdiodenchip nach einem der Ansprüche 12 bis 15,
wobei die Schicht eine Dicke zwischen einschließlich 5 um und einschließlich 250 um aufweist.

17. Lumineszenzdiodenchip nach einem der Ansprüche 12 bis 15,
wobei die Schicht eine Dicke zwischen einschließlich 10 µm und einschließlich 50 um aufweist.

18. Lumineszenzdiodenchip nach einem der Ansprüche 12 bis 17,
wobei der Lumineszenzdiodenchip ein Dünnfilm-Lumineszenzdiodenchip ist.

19. Lumineszenzdiodenchip nach einem der Ansprüche 12 bis 18,
wobei das Lumineszenzkonversionsmaterial mindestens einen organischen Leuchtstoff aufweist.

## Claims

1. A method for producing at least one luminescence diode chip provided with a luminescence conversion material comprising at least one phosphor, comprising the steps of:
- preparing a base body comprising a layer sequence that is intended for the luminescence diode chip and is suitable for emitting an electromagnetic radiation;
- applying a cap layer to at least one main surface of the base body;
- introducing at least one cavity into the cap layer; and
- applying luminescence conversion material to the base body in such a way that the cavity is completely or partially filled, wherein only a portion of the cap layer is selectively removed after the application of the luminescence conversion material.

2. The method according to claim 1,
wherein the cap layer comprises a photo-structurable material and/or a reflective material.

3. The method according to claim 1 or 2,
wherein the removal is effected mechanically and/or chemically.

4. The method according to claim 1 or 2,
wherein in addition to the luminescence conversion material at least the cap layer also comprises at least one phosphor.

5. The method according to one of the preceding claims,
wherein the base body comprises on the main surface at least one electrical contact area for electrically connecting the at least one luminescence diode chip, and the cavity is introduced in such a way as to be offset laterally from the contact area of the cap layer.

6. The method according to one of the preceding claims,
wherein the luminescence conversion material comprises at least one material from the group consisting of silicones, siloxanes, spin-on oxides and photo-structurable materials.

7. The method according to one of the preceding claims,
wherein the luminescence conversion material is applied in the form of a liquid, curable substance and is subsequently cured.

8. The method according to claim 7,
wherein before curing, excess the luminescence conversion material is at least partially removed by being wiped away.

9. A method for producing at least one luminescence diode chip provided with a luminescence conversion material comprising at least one phosphor, comprising the steps of:
- preparing a base body comprising a layer sequence that is intended for the luminescence diode chip and is suitable for emitting an electromagnetic radiation;
- applying a photo-structurable cap layer comprising the phosphor to at least one main surface of the base body; and
- introducing at least one cavity into the cap layer, wherein the cap layer is photo-structurable and the course of the cross section or of the inner walls of the cavity is adjusted at least partially by exposure to light of nonuniform intensity, so that
- its cross section becomes larger or smaller with increasing depth, or
- its inner walls extend at least partially obliquely or curvedly with respect to a main plane of extension of the main surface.

10. The method according to one of the preceding claims,
wherein the base body is provided for a plurality of luminescence diode chips.

11. The method according to one of the preceding claims,
wherein the base body is a wafer or a carrier to which the layer sequence or a plurality of such layer sequences is applied.

12. A luminescence diode chip comprising a base body, which is suitable for emitting electromagnetic radiation and is provided on at least one main surface with a luminescence conversion material comprising at least one phosphor, and the luminescence conversion material is present as a layer whose lateral flanks are deliberately shaped, at least in part, so as to extend obliquely or curvedly with respect to a main plane of extension of the main surface,
**characterized in that**
- the luminescence conversion material is laterally adjacent to a reflective material which comprises a photo-structurable material; or
- the luminescence conversion material comprises at least one phosphor that is present at least partially in the form of nanoparticles.

13. The luminescence diode chip according to claim 12,
wherein the luminescence conversion material comprises at least one material from the group consisting of silicones, siloxanes, spin-on oxides and photo-structurable materials.

14. A luminescence diode chip comprising a base body, which is suitable for emitting electromagnetic radiation and is provided on at least one main surface with a luminescence conversion material comprising at least one phosphor, **characterized in that**
- the luminescence conversion material comprises a photo-structurable material, and
- the luminescence conversion material comprises at least one phosphor that is present at least partially in the form of nanoparticles.

15. The luminescence diode chip according to claim 14,
wherein the luminescence conversion material is photo-structured.

16. The luminescence diode chip according to one of claims 12 to 15,
wherein the layer has a thickness between 5 µm inclusive and 250 µm inclusive.

17. The luminescence diode chip according to one of claims 12 to 15,
wherein the layer has a thickness between 10 µm inclusive and 50 µm inclusive.

18. The luminescence diode chip according to one of claims 12 to 17,
wherein the luminescence diode chip is a thin-film luminescence diode chip.

19. The luminescence diode chip according to one of claims 12 to 18,
wherein the luminescence conversion material comprises at least one organic phosphor.

## Revendications

1. Procédé de fabrication d'au moins une puce à diode luminescente qui est munie d'une matière de conversion de luminescence présentant au moins une substance luminescente, comprenant les étapes:
- fourniture d'un corps de base qui présente une succession de couches pour la puce à diode luminescente, laquelle est apte à émettre un rayonnement électromagnétique;
- application d'une couche de recouvrement sur au moins une surface principale du corps de base;
- réalisation d'au moins une cavité dans la couche de recouvrement; et
- application de la matière de conversion de luminescence sur le corps de base de manière à ce que la cavité soit complètement ou partiellement remplie, seulement une partie de la couche de recouvrement étant sélectivement enlevée après l'application de la matière de conversion de luminescence.

2. Procédé selon la revendication 1,
la couche de recouvrement présentant une matière photostructurable et/ou une matière réfléchissante.

3. Procédé selon la revendication 1 ou 2,
l'enlèvement étant réalisé mécaniquement et/ou chimiquement.

4. Procédé selon la revendication 1 ou 2,
au moins également la couche de recouvrement, outre la matière de conversion de luminescence, présentant au moins une substance luminescente.

5. Procédé selon l'une quelconque des revendications précédentes,
le corps de base présentant sur la surface principale au moins une surface de contact électrique pour le raccordement électrique de l'au moins une puce à diode électroluminescente, et la cavité étant réalisée de manière latéralement décalée par rapport à la surface de contact de la couche de recouvrement.

6. Procédé selon l'une quelconque des revendications précédentes,
la matière de conversion de luminescence présentant au moins une matière provenant du groupe consistant en des silicones, des siloxanes, des oxydes spin on et des matières photostructurables.

7. Procédé selon l'une quelconque des revendications précédentes,
la matière de conversion de luminescence étant appliquée sous forme d'une substance liquide durcissable et étant ensuite durcie.

8. Procédé selon la revendication 7,
la matière de conversion de luminescence excessive étant enlevée au moins en partie par raclage avant le durcissement.

9. Procédé de fabrication d'au moins une puce à diode électroluminescente qui est pourvue d'une matière de conversion de luminescence présentant au moins une substance luminescente, comprenant les étapes:
- fourniture d'un corps de base qui présente une succession de couches pour la puce à diode luminescente, laquelle est apte à émettre un rayonnement électromagnétique;
- application d'une couche de recouvrement photostructurable, laquelle présente la substance luminescente, sur au moins une surface principale du corps de base; et
- réalisation d'au moins une cavité dans la couche de recouvrement, la couche de recouvrement étant photostructurable, et une allure de la section transversale ou des parois intérieures de la cavité étant réglée au moins en partie par exposition irrégulièrement forte de manière à ce que
- sa section transversale augmente ou diminue au fur et à mesure que la profondeur augmente, ou
- à ce que ses parois intérieures s'étendent au moins en partie de manière oblique ou courbe par rapport à un plan d'étendue principale de la surface principale.

10. Procédé selon l'une quelconque des revendications précédentes,
le corps de base étant prévu pour une pluralité de puces à diode luminescente.

11. Procédé selon l'une quelconque des revendications précédentes,
le corps de base étant une tranche ou un support sur lequel la succession de couches est appliquée ou plusieurs de telles successions de couches sont appliquées.

12. Puce à diode luminescente comprenant un corps de base qui est apte à émettre un rayonnement électromagnétique et qui est pourvu d'une matière de conversion de luminescence sur au moins une surface principale, laquelle matière présente au moins une substance luminescente, et la matière de conversion de luminescence étant présente en tant qu'une couche dont les flancs latéraux sont formés, au moins en partie sélectivement, de manière à ce qu'ils s'étendent obliquement ou de manière courbée par rapport à un plan d'étendue principale de la surface principale, **caractérisée en ce que**
- la matière de conversion de luminescence est latéralement adjacente à une matière réfléchissante qui présente une matière photostructurable; ou
- **en ce que** la matière de conversion de luminescence présente au moins une substance luminescente qui est présente au moins en partie sous forme de nanoparticules.

13. Puce à diode luminescente selon la revendication 12, la matière de conversion de luminescence présentant au moins une matière provenant du groupe consistent en des silicones, des siloxanes, des oxydes spin on et des matières photostructurables.

14. Puce à diode luminescente comprenant un corps de base qui est apte à émettre un rayonnement électromagnétique et qui est pourvu d'une matière de conversion de luminescence sur au moins une surface principale, laquelle matière présente au moins une substance luminescente,
**caractérisée en ce que**
- la matière de conversion de luminescence présente une matière photostructurable, et
- **en ce que** la matière de conversion de luminescence présente au moins une substance luminescente qui est présente au moins en partie sous forme de nanoparticules.

15. Puce à diode électroluminescente selon la revendication 14,
dans laquelle la matière de conversion de luminescence est photostructurée.

16. Puce à diode électroluminescente selon l'une quelconque des revendications 12 à 15,
la couche présentant une épaisseur entre y compris 5 µm et y compris 250 µm.

17. Puce à diode luminescente selon l'une quelconque des revendications 12 à 15,
la couche présentant une épaisseur entre y compris 10 µm et y compris 50 µm.

18. Puce à diode luminescente selon l'une quelconque des revendications 12 à 17,
la puce à diode électroluminescente étant une puce à diode luminescente à couche mince.

19. Puce à diode luminescente selon l'une quelconque des revendications 12 à 18,
la matière de conversion de luminescence présentant au moins une substance luminescente organique.
